# EUROPEAN PATENT APPLICATION

(11) **EP 4 593 086 A1**
(43) Date of publication of application: **30.07.2025**
(21) Application number: 24153703.4
(22) Date of filing: 24.01.2024
(51) Int. Cl.: H01L 29/739, H01L 29/78, H01L 29/10, H01L 29/16, H01L 21/266, H01L 21/331, H01L 21/336, H01L 29/06, H01L 29/20

(54) **METHOD OF MANUFACTURING A SEMICONDUCTOR DEVICE INCLUDING A WIDE BAND GAP SEMICONDUCTOR BODY**

(71) Applicant: Infineon Technologies AG, 85579 Neubiberg (DE)
(72) Inventor: WEBER, Hans, 9500 Villach (AT); SIEMIENIEC, Thomas Ralf, 9500 Villach (AT); MODER, Iris, 9500 Villach (AT)
(74) Representative: Müller Hoffmann & Partner

(57) **Abstract**

A method of manufacturing a semiconductor device (100) is proposed. The method includes forming a first mask pattern (102) over a first surface (104) of a wide band gap semiconductor body (106). The method further includes forming a trench (108) extending from an opening (1021) in the first mask pattern (102) into the wide band gap semiconductor body (106), wherein the trench (108) includes a first sidewall (1081) and an opposite second sidewall (1082). The method further includes forming a first spacer mask pattern (110) including a first spacer portion (1101) covering at least the first sidewall (1081) and a second spacer portion (1102) covering at least the second sidewall (1082). The method further includes forming a second mask pattern (112) in the trench (108) between the first spacer portion (1101) of the first spacer mask pattern (110) and the second spacer portion (1102) of the first spacer mask pattern (110). The method further includes exposing a trench portion (1083) of the trench (108) by removing at least a portion of the second spacer portion (1102) from the trench (108), and introducing dopants through the trench portion (1083) into the wide band gap semiconductor body (106).

## Description

### TECHNICAL FIELD

The present disclosure is related to a method of manufacturing a semiconductor device, in particular to a method of manufacturing a semiconductor device including a wide band gap semiconductor body.

### BACKGROUND

Technology development of new generations of wide band gap semiconductor devices, e.g. insulated gate field effect transistors (IGFETs) such as metal oxide semiconductor field effect transistors (MOSFETs) or insulated gate bipolar transistors (IGBTs), aims at improving electrical device characteristics and reducing costs by shrinking device geometries. Although costs may be reduced by shrinking device geometries, a variety of tradeoffs and challenges have to be met when increasing device functionalities per unit area. For example, reducing the area-specific on-state resistance, RonxA, may be challenging in view of process-related variations when arranging trenches relative to doped regions or doped regions relative to one another. Such process-related variations may be caused by process technology including different lithographic levels, for example.

There is a need for improving manufacturing methods of wide band gap semiconductor devices.

### SUMMARY

An example of the present disclosure relates to a method of manufacturing a semiconductor device. The method includes forming a first mask pattern over a first surface of a wide band gap semiconductor body. The method further includes forming a trench extending from an opening in the first mask pattern into the wide band gap semiconductor body. The trench includes a first sidewall and an opposite second sidewall. The method further includes forming a first spacer mask pattern including a first spacer portion covering at least the first sidewall and a second spacer portion covering at least the second sidewall. The method further includes forming a second mask pattern in the trench between the first spacer portion of the first spacer mask pattern and the second spacer portion of the first spacer mask pattern. The method further includes exposing a trench portion of the trench by removing at least a portion of the second spacer portion from the trench and introducing dopants through the trench portion into the wide band gap semiconductor body.

Those skilled in the art will recognize additional features and advantages upon reading the following detailed description and on viewing the accompanying drawings.

### BRIEF DESCRIPTION OF THE DRAWINGS

The accompanying drawings are included to provide a further understanding of the embodiments and are incorporated in and constitute a part of this specification. The drawings illustrate embodiments of manufacturing wide band gap semiconductor devices and together with the description serve to explain principles of the embodiments. Further embodiments are described in the following detailed description and the claims.
Figs. 1A to 1F are cross-sectional views for schematically and exemplarily illustrating process features of manufacturing a wide band gap semiconductor device.
Fig. 2 is a cross-sectional view for illustrating a process feature related to Fig. 1E.
Fig. 3 is a cross-sectional view for illustrating a process feature related to formation of a spacer mask pattern for forming a semiconductor region self-aligned to edges of a trench.
Fig. 4 is a cross-sectional view for illustrating a process feature related to Fig. 3.
Figs. 5 and 6 are cross-sectional views for illustrating process features related to formation of a semiconductor region self-aligned to edges of a trench.
Figs. 7A to 7D are cross-sectional views for schematically and exemplarily illustrating process features of manufacturing a wide band gap semiconductor device.
Fig. 8 is a schematic cross-sectional view for illustrating a configuration example of an n-channel FET manufactured by process features as described with reference to Figs. 1A to 6.

### DETAILED DESCRIPTION

In the following detailed description, reference is made to the accompanying drawings, which form a part hereof and in which are shown by way of illustrations specific examples in which semiconductor substrates may be processed. It is to be understood that other examples may be utilized and structural or logical changes may be made without departing from the scope of the present disclosure. For example, features illustrated or described for one example can be used on or in conjunction with other examples to yield yet a further example. It is intended that the present disclosure includes such modifications and variations. The examples are described using specific language, which should not be construed as limiting the scope of the appending claims. The drawings are not scaled and are for illustrative purposes only. Corresponding elements are designated by the same reference signs in the different drawings if not stated otherwise.

The terms "having", "containing", "including", "comprising" and the like are open, and the terms indicate the presence of stated structures, elements or features but do not preclude the presence of additional elements or features. The articles "a", "an" and "the" are intended to include the plural as well as the singular, unless the context clearly indicates otherwise.

The term "electrically connected" may describe a permanent low-resistive connection between electrically connected elements, for example a direct contact between the concerned elements or a low-resistive connection via a metal and/or heavily doped semiconductor material. The term "electrically coupled" may include that one or more intervening element(s) adapted for signal and/or power transmission may be connected between the electrically coupled elements, for example, elements that are controllable to temporarily provide a low-resistive connection in a first state and a high-resistive electric decoupling in a second state.

If two elements A and B are combined using an "or", this is to be understood to disclose all possible combinations, i.e. only A, only B as well as A and B, if not explicitly or implicitly defined otherwise. An alternative wording for the same combinations is "at least one of A and B" or "A and/or B". The same applies, mutatis mutandis, for combinations of more than two elements.

Ranges given for physical dimensions include the boundary values. For example, a range for a parameter y from a to b reads as a ≤ y ≤ b. The same holds for ranges with one boundary value like "at most" and "at least".

Main constituents of a layer or a structure from a chemical compound or alloy are such elements which atoms form the chemical compound or alloy. For example, silicon (Si) and carbon (C) are the main constituents of a silicon carbide (SiC) layer.

The term "on" is not to be construed as meaning only "directly on". Rather, if one element is positioned "on" another element (e.g., a layer is "on" another layer or "on" a substrate), a further component (e.g., a further layer) may be positioned between the two elements (e.g., a further layer may be positioned between a layer and a substrate if the layer is "on" said substrate).

The description and drawings merely illustrate the principles of the disclosure. Furthermore, all examples recited herein are principally intended expressly to be only for illustrative purposes to aid the reader in understanding the principles of the disclosure and the concepts contributed by the inventor(s) to furthering the art. All statements herein reciting principles, aspects, and examples of the disclosure, as well as specific examples thereof, are intended to encompass equivalents thereof.

It is to be understood that the disclosure of multiple acts, processes, operations, steps or functions disclosed in the specification or claims may not be construed as to be within the specific order, unless explicitly or implicitly stated otherwise, e.g. by expressions like "thereafter", for instance for technical reasons. Therefore, the disclosure of multiple acts or functions will not limit these to a particular order unless such acts or functions are not interchangeable for technical reasons. Furthermore, in some examples a single act, function, process, operation or step may include or may be broken into multiple sub-acts, -functions, -processes, -operations or-steps, respectively. Such sub acts may be included and part of the disclosure of this single act unless explicitly excluded.

A configuration example of a method of manufacturing a semiconductor device may include forming a first mask pattern over a first surface of a wide band gap semiconductor body. The method may further include forming a trench extending from an opening in the first mask pattern into the wide band gap semiconductor body, wherein the trench includes a first sidewall and an opposite second sidewall. The method may further include forming a first spacer mask pattern including a first spacer portion covering at least the first sidewall and a second spacer portion covering at least the second sidewall. The method may further include forming a second mask pattern in the trench between the first spacer portion of the first spacer mask pattern and the second spacer portion of the first spacer mask pattern. The method may further include exposing a trench portion of the trench by removing at least a portion of the second spacer portion from the trench and introducing dopants through the trench portion into the wide band gap semiconductor body.

The semiconductor device may be part of an integrated circuit or may be a discrete semiconductor device or a semiconductor module, for example. The semiconductor device may be or may include an insulated gate field effect transistor (IGFET) such as a metal oxide semiconductor field effect transistor (MOSFET) or an insulated gate bipolar transistor (IGBT), for example. The semiconductor device may be a vertical semiconductor device having a load current flow between the first surface and the second surface opposite to the first surface. The vertical power semiconductor device may be configured to conduct currents of more than 1A, or more than 10 A, or more than 30 A, or more than 50 A, or more than 75 A, or even more than 100 A, and may be further configured to block voltages between load electrodes, e.g. between collector and emitter on an IGBT, or between drain and source of a MOSFET, in the range of several hundreds of up to several thousands of volts, e.g. 400 V, 650 V, 1.2 kV, 1.7 kV, 3.3 kV, 4.5 kV, 5.5 kV, 6 kV, 6.5 kV, 10 kV. The blocking voltage may correspond to a voltage class specified in a datasheet of the power semiconductor device, for example.

The semiconductor device may be based on a wide band gap semiconductor body from a crystalline wide band gap semiconductor material having a band gap larger than the band gap of silicon, i.e. larger than 1.12 eV. The wide band gap semiconductor material may have a hexagonal crystal lattice and may be silicon carbide (SiC) or gallium nitride (GaN), by way of example. For example, the semiconductor material may be 2H-SiC (SiC of the 2H polytype), 6H-SIC or 15R-SiC. According to an example, the semiconductor material is silicon carbide of the 4H polytype (4H-SiC). The semiconductor body may include or consist of a semiconductor substrate having none, one or more than one semiconductor layers, e.g. epitaxially grown layers, thereon.

The first surface may be a front surface or a top surface of the wide band gap semiconductor body, and the wide band gap semiconductor body may further have a second surface that may be a back surface or a rear surface of the wide band gap semiconductor body, for example. The wide band gap semiconductor body may be attached to a lead frame via the second surface, for example. Over the first surface of the wide band gap semiconductor body, bond pads may be arranged and bond wires may be bonded on the bond pads, for example.

For example, the trench may be stripe-shaped and may define the dimensions of a trench gate structure formed in the trench. Forming the trench gate structure may include forming a trench gate dielectric, e.g. by thermal oxidation, and forming a trench gate electrode on the trench gate dielectric in the trench. The trench may also have another layout or geometry in a plan view, e.g. hexagonal, square, circular, elliptic. The trench gate electrode structure may include one or more conductive material(s), e.g. metal, metal alloys, e.g. Ni, Cu, Au, AlCu, Ag, Mo, Ta, W, or alloys thereof, metal compounds, e.g. TiN, MoN, highly doped semiconductor material such as highly doped polycrystalline silicon or silicides, e.g. TiSi2. The one or more conductive materials may form a layer stack, for example. An exemplary layer stack may include a TiN barrier and a W filling. The trench gate electrode structure may be electrically connected to a gate pad via the gate interconnection structure, for example. The gate pad and, for example, a first load electrode pad, e.g. a source pad of a MOSFET or an emitter pad of an IGBT, may be part of a wiring area over the wide band gap semiconductor body. Forming the wiring area may include forming one or more than one, e.g. two, three, four or even more wiring levels. Each wiring level may be formed by a single one or a stack of conductive layers, e.g. metal layer(s). The wiring levels may be lithographically patterned, for example. Between stacked wiring levels, an interlayer dielectric structure may be arranged. Contact plug(s) and/or contact line(s) may be formed in openings of the interlayer dielectric structure to electrically connect parts, e.g. metal lines or contact areas, of different wiring levels to one another.

For realizing a desired current carrying capacity, the wide band gap semiconductor device may be designed by a plurality of parallel-connected wide band gap semiconductor device cells. The parallel-connected wide band gap semiconductor device cells may, for example, be wide band gap semiconductor device cells formed in the shape of a strip or a strip segment. Of course, the wide band gap semiconductor device cells can also have any other shape, e.g. circular, elliptical, polygonal such as hexagonal or octahedral. The wide band gap semiconductor device cells may be arranged in the active transistor area of the wide band gap semiconductor body. The active transistor area may be an area where an emitter region of an IGBT (or a source region of a MOSFET) and a collector region of an IGBT (or a drain region of a MOSFET) are arranged opposite to one another along the vertical direction. In the active transistor area, a load current may enter or exit the wide band gap semiconductor body of the semiconductor device, e.g. via contact plugs on the first surface of the wide band gap semiconductor body. The wide band gap semiconductor device may further include an edge termination area that may include a termination structure. In a blocking mode or in a reverse biased mode of the wide band gap semiconductor device, the blocking voltage between the active transistor area and a field-free region laterally drops across the termination structure. The termination structure may have a higher or a slightly lower voltage blocking capability than the active area. The termination structure may include a junction termination extension (JTE) with or without a variation of lateral doping (VLD), one or more laterally separated guard rings, or any combination thereof, for example.

The first mask pattern may be formed as a first hard mask pattern, e.g. oxide hard mask pattern. The first mask pattern may be defined by a photolithography process, for example. Dimensions and arrangement of opening(s) in the first mask pattern may define a layout of trench(es) for forming the trench gate structure of the semiconductor device, for example. The trench(es) may be formed by an etch process, for example. Before forming the first mask pattern, the method may further include introducing dopants into the wide band gap semiconductor body, e.g. by ion implantation, for defining semiconductor layers in the wide band gap semiconductor body, e.g. a current spread layer or a body layer.

For example, the dopants may be introduced into the wide band gap semiconductor body 106 through a bottom side and/or the second sidewall 1082 of the trench 108 by one or more ion implantation processes. Ion implantation parameters, e.g. ion implantation energy, ion implantation dose, implant tilt angle, as well as dopants species, e.g. n- or -p type dopants, allow for forming one or more p- and/or n-type semiconductor regions that are self-aligned with respect to the edges of the trench. The first mask pattern may not only allow for defining the trench(es) but may also serve as an ion implantation mask on the mesa confined by opposite trenches when implanting the dopants through the trench opening. And, in addition, the first mask pattern may also serve as a mechanical support structure for the first spacer mask pattern since the first spacer mask pattern may not only be formed in the trench but protrude from the first surface of the wide band gap semiconductor body. Thus, process features described herein may allow for improving the manufacturing method with respect to critical dimensions. Thereby, smaller transistor cell layouts or transistor cell layouts with higher manufacturing yield may be achieved.

For example, the method may further include forming a third mask pattern over the first mask pattern. The third mask pattern may cover a top surface of the first spacer portion of the first spacer mask pattern. A top surface of the second spacer portion of the first spacer mask pattern may be exposed by an opening in the third mask pattern.

For example, exposing the trench portion may further include selectively etching the second spacer portion of the first spacer mask pattern with respect to any of the first mask pattern, or the second mask pattern, or the third mask pattern.

For example, a material of the first spacer portion of the first spacer mask pattern may be polycrystalline silicon. A material of at least one of the first mask pattern or the second mask pattern may be an oxide of silicon.

For example, introducing dopants through the trench portion into the wide band gap semiconductor body may include introducing dopants through a bottom side or through the second sidewall of the trench into the wide band gap semiconductor body by ion implantation. The dopants may define a p-doped shielding region adjoining to a bottom side and/or the second sidewall of the trench. The p-doped shielding region is self-aligned to the edges of the trench.

For example, the method may further include removing the first mask pattern. The method may further include forming a second spacer mask pattern including a first spacer portion in the trench portion between the wide band gap semiconductor body and the second mask pattern. The second spacer mask pattern may further include a second spacer portion laterally adjoining to the first spacer portion of the first spacer mask pattern.

For example, removing the first mask pattern may include forming a fourth mask pattern over the first mask pattern. The fourth mask pattern may cover a top surface of the second mask pattern and a top surface of the first spacer portion of the first spacer mask pattern. A part of the first mask pattern may be exposed by an opening in the fourth mask pattern.

For example, removing the first mask pattern may further include selectively etching the first mask pattern with respect to any of the first spacer portion of the first spacer mask pattern, or the fourth mask pattern.

For example, a material of the fourth mask pattern may be a resist material.

For example, the method may further include introducing dopants through an opening in the second spacer mask pattern into the wide band gap semiconductor body by ion implantation. This may allow for defining a further semiconductor region in a self-aligned manner to the edges of the trench by ion implantation through the opening in the second spacer mask, e.g. a p-doped auxiliary or contact region for electrically connecting the shielding region to a source electrode, for example

For example, the method may further include forming a sixth mask pattern laterally adjoining to the first and second spacer portions of the second mask pattern. The method may further include forming a seventh mask pattern over the sixth mask pattern. The seventh mask pattern may cover a top surface of the second mask pattern and a top surface of the first spacer portion of the second spacer mask pattern. A top surface of the second spacer portion of the second spacer mask pattern may be exposed by an opening in seventh mask pattern.

For example, the method may further include exposing a surface portion of the wide band gap semiconductor body by selectively etching the second spacer portion of the second spacer mask pattern with respect to any of the first spacer portion of the first spacer mask pattern, or the sixth mask pattern or the seventh mask pattern. This may allow for defining a further semiconductor region in a self-aligned manner to the edges of the trench by ion implantation through the exposed surface portion, e.g. an n⁺-doped source region.

For example, a material of the sixth mask pattern may be polycrystalline silicon, and a material of or the seventh mask pattern may be an oxide of silicon or silicon nitride.

For example, the method may further include introducing dopants through the surface portion of the wide band gap semiconductor body into the wide band gap semiconductor body by ion implantation. The dopants may define an n-doped source region, for example.

For example, the method may further include, before forming the first mask pattern, introducing dopants through the first surface into the wide band gap semiconductor body. For example, the dopants may be introduced into the wide band gap semiconductor body by ion implantation. The ion implantation may be unmasked with respect to a transistor cell area, for example. For example, the dopants may define a body region of a FET, for example. In addition or as an alternative, the dopants may define a current spread region of a FET, for example. Dopant conductivity types of dopants defining a body region and a current spread region may be different. For example, for an n-channel SiC FET, n-type dopants, e.g. nitrogen (N) or phosphorus (P), may define the current spread region, and p-type dopants, e.g. boron (B) or aluminum (Al) may define the body region.

For example, after forming the trench and before forming the first spacer mask pattern, the method may further include forming a liner lining a bottom side and sidewalls of the trench. The liner may further line a top side and sidewalls of the first mask pattern. For example, a material of the liner may be chosen with respect to etch selectivity vis-à-vis the second mask pattern.

For example, exposing the trench portion may further include removing at least a portion, e.g. part of or all of the second mask pattern. Removing the second mask pattern may be carried out by an etch process that is selective with respect to the liner and the spacer portion, for example.

For example, a thickness of the first spacer portion may be increased to a target thickness. Increasing of a thickness of the first spacer portion may be carried out by an appropriate process such as, for example and depending on the material of the first spacer portion, an oxidation process. For example, an oxidation process may be used for a first spacer portion formed by polycrystalline silicon.

Details with respect to structure, or function, or technical benefit of features described above with respect to a wide band gap semiconductor device such as a FET, or IGBT likewise apply to the exemplary methods described herein. Processing the semiconductor body may comprise one or more optional additional features corresponding to one or more aspects mentioned in connection with the proposed concept or one or more examples described above or below.

Some of the above and below examples are described in connection with a silicon carbide substrate. Alternatively, a wide band gap semiconductor substrate, e.g. a wide band gap wafer, may be processed, e.g. comprising a wide band gap semiconductor material different from silicon carbide. The wide band gap semiconductor wafer may have a band gap larger than the band gap of silicon (1.12 eV). For example, the wide band gap semiconductor wafer may be a silicon carbide (SiC) wafer, or gallium arsenide (GaAs) wafer, or a gallium nitride (GaN) wafer.

More details and aspects are mentioned in connection with the examples described above or below. Processing a wide band gap semiconductor body such as a wafer may comprise one or more optional additional features corresponding to one or more aspects mentioned in connection with the proposed concept or one or more examples described above or below.

In the following, further examples of field effect transistors, FETs, are explained in connection with the accompanying drawings. Functional and structural details described with respect to the examples above shall likewise apply to the exemplary embodiments illustrated in the figures and described further below. In the illustrated examples, n-channel FETs are illustrated. However, the examples described herein may also be applied to p-channel devices, e.g. p-channel MOSFETs or p-channel devices IGBTs.

Details with respect to structure, or function, or technical benefit of features described above likewise apply to the examples below and vice versa.

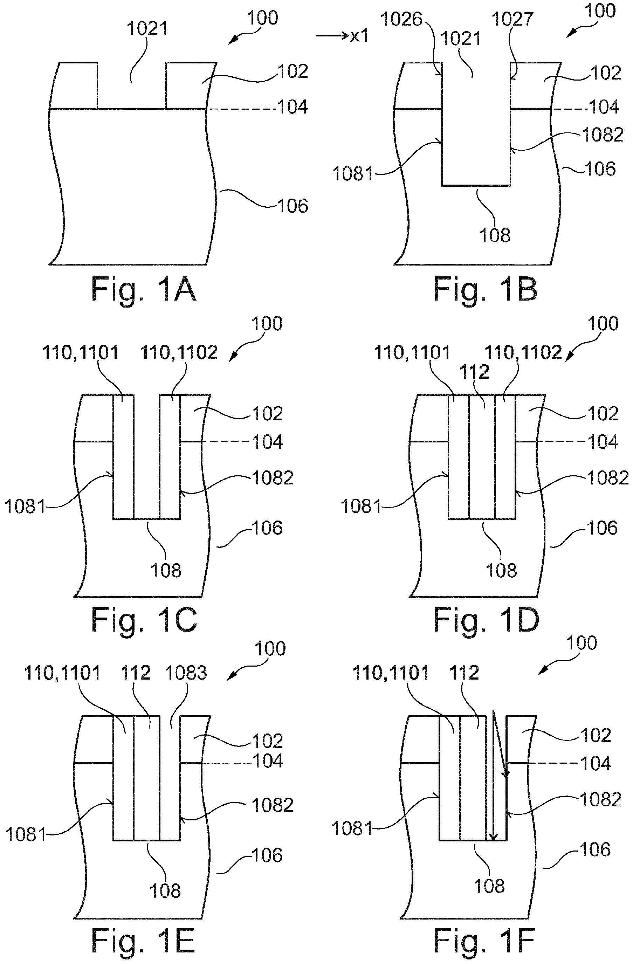

The schematic cross-sectional views of Figs. 1A to 1F schematically and exemplarily illustrate process features of manufacturing a semiconductor device 100.

Referring to the schematic cross-sectional view of Fig. 1A, a first mask pattern 102 is formed over a first surface 104, e.g. front surface, of a wide band gap semiconductor body 106, e.g. SiC semiconductor body. The wide band gap semiconductor body 106 may include a semiconductor substrate and none, one or more semiconductor layers thereon, e.g. a SiC semiconductor substrate and none, one or more SiC semiconductor layers thereon. The first mask pattern 102 may be formed as a hard mask pattern, e.g. an oxide hard mask pattern, by a photolithography process. The first mask pattern 102 includes openings, e.g. an opening 1021. The opening 1021 and further openings not illustrated in Fig. 1A may define a transistor cell geometry of the semiconductor device 100, e.g. a stripe-shaped transistor cell geometry. In case of a stripe-shaped cell geometry, a width of the opening 1021 may be in the range of hundreds of nanometers, e.g. 300 nm to 2 µm, and a lateral distance between neighboring openings (defining, for example, a mesa width of the transistor cell) may also be in the range of hundreds of nanometers, e.g. 300 nm to 2 µm.

Referring to the schematic cross-sectional view of Fig. 1B, a trench 108, e.g. a trench for a trench gate structure, is formed and extends from the opening 1021 in the first mask pattern 102 into the wide band gap semiconductor body 106. For example, the trench 108 may be formed by one or more etch processes, e.g. anisotropic etching techniques such as reactive ion etching (RIE). The trench 108 has a first sidewall 1081 that is arranged opposite to a second sidewall 1082 of the trench 108 along a first lateral direction x1.

Referring to the schematic cross-sectional view of Fig. 1C, a first spacer mask pattern 110 is formed on the wide band gap semiconductor body 106 and the first mask pattern 102. The first mask pattern 102 thus not only serves for defining the trench 108 but also serves as a mechanical support structure for an upper part of the first spacer mask pattern 110 that protrudes from the first surface 104. The first spacer mask pattern 110 may be formed by a layer deposition process followed by an etch process removing material of the deposited layer from a bottom side of the trench 108 and from a top side of the first mask pattern 102. As an outcome of the spacer etch process, a first spacer portion 1101 and a second spacer portion 1102 may remain, the first spacer portion 1101 covering at least the first sidewall 1081 and the second spacer portion 1102 covering at least the second sidewall 1082. The first spacer portion 1081 also covers a first sidewall 1026 of the first mask pattern 102 and a second sidewall 1027 of the first mask pattern 102. The second sidewall 1027 is opposite to the first sidewall 1026 along the first lateral direction x1. A material of the first and second spacer portions 1101, 1102 of the first spacer mask pattern 110 may be appropriately selected for allowing selective etching of the second spacer portion 1102 with respect to any of the first mask pattern 102 or the wide band gap semiconductor body 106. For example, the first spacer portion 1101 and the second spacer portion 1102 of the first spacer mask pattern 110 may be formed by polycrystalline silicon, e.g. undoped polycrystalline silicon. The first mask pattern 102 may be formed by an oxide of silicon, for example.

Referring to the schematic cross-sectional view of Fig. 1D, a second mask pattern 112 is formed in the trench 108 between the first spacer portion 1101 of the first spacer mask pattern 110 and the second spacer portion 1102 of the first spacer mask pattern 110. The second mask pattern 112 may be formed by a layer deposition process followed by removing a part of the deposited layer that is arranged on the first mask pattern 110 and on the first and second spacer portions 1101, 1102 of the first spacer mask pattern 110. For example, the part of the deposited layer may be removed by chemical mechanical polishing (CMP), or by a combination of dry etching and CMP, for example. For example, the deposited layer may be a Tetraethyl orthosilicate (TEOS) layer. Patterning of the TEOS layer may also be carried out by a spacer etch process, for example.

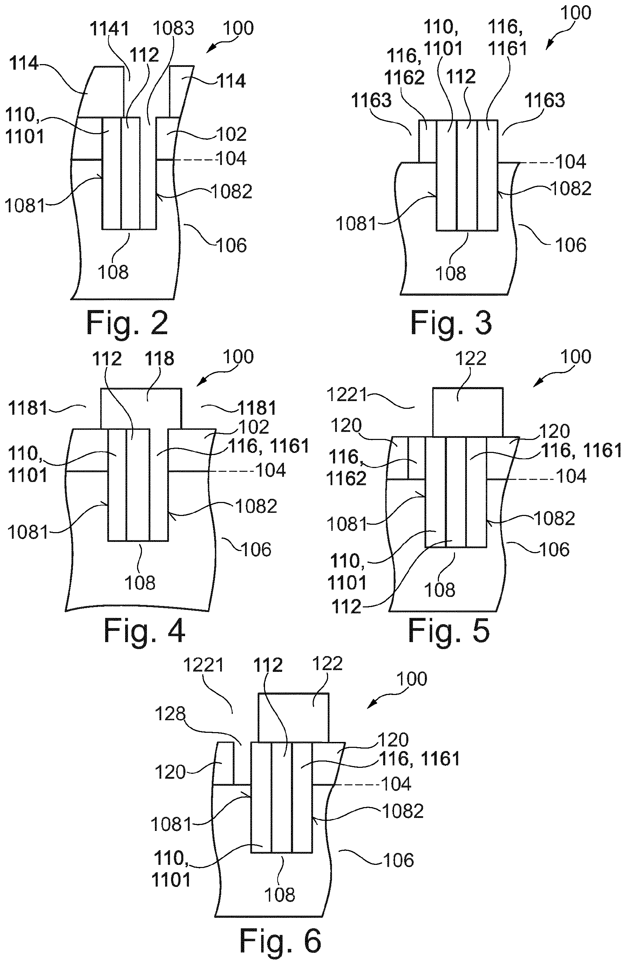

Referring to the schematic cross-sectional view of Fig. 1E, a trench portion 1083 of the trench 108 is exposed by removing at least a portion of the second spacer portion 1102 from the trench 108. The trench portion 1082 may be exposed by selective etching of the second spacer portion 1102 of the first spacer mask pattern 110 with respect to each of the first mask pattern 102, the wide band gap semiconductor body 106, and the second mask pattern 112 (see also description related to Fig. 2 further below).

Referring to the schematic cross-sectional view of Fig. 1F, dopants are introduced through the exposed trench portion 1083 into the wide band gap semiconductor body 106. For example, a p-doped shielding region may be formed in a self-aligned manner with respect to the edges of the trench 102. The first mask 102 serves as an ion implantation mask on the mesa confined by opposite trenches 108 when implanting the dopants through the exposed trench portion 1083.

The schematic cross-sectional view of Fig. 2 is related to the process feature illustrated in Fig. 1E. Referring to Fig. 2, exposing the trench portion 1083 includes forming a third mask pattern 114 over the first mask pattern 102. The third mask pattern 114 covers a top surface of the first spacer portion 1101 of the first spacer mask pattern 110. Prior to removing the second spacer portion 1102 from the trench 108, a top surface of the second spacer portion 1102 of the first spacer mask pattern 110 is exposed by an opening 1141 in the third mask pattern 114. For example, the third mask pattern 114 may include a resist mask pattern and an auxiliary mask pattern between the resist mask pattern and the first spacer mask pattern 110. The auxiliary mask pattern may protect the first spacer portion 1101 when etching the second spacer portion 1102 for exposing the trench portion 1083, for example. For example, the auxiliary mask pattern may include or be formed by a TEOS layer and/or nitride layer.

Further semiconductor regions may be arranged in a self-aligned manner with respect to the trench 108 or mesa region defined by opposite trenches. Referring to the schematic cross-sectional view of Fig. 3, after removing the first mask pattern 102, a second spacer mask pattern 116 is formed. The second spacer mask pattern 116 includes a first spacer portion 1161 in the trench portion 1083 between the wide band gap semiconductor body 106 and the second mask pattern 112. The second spacer mask pattern 116 further includes a second spacer portion 1162 laterally adjoining to the first spacer portion 1101 of the first spacer mask pattern 110.

Exemplary process features for processing the wide band gap semiconductor body from the stage of process illustrated in Fig. 1F to the stage of process illustrated in Fig. 3 are described with reference to the exemplary cross-sectional view of Fig. 4.

Referring to Fig. 4, removing the first mask pattern 102 includes forming a fourth mask pattern 118, e.g. a resist mask pattern, over the first mask pattern 102. The fourth mask pattern 118 covers a top surface of the second mask pattern 112 and a top surface of the first spacer portion 1101 of the first spacer mask pattern 110. The fourth mask pattern 118 also fills or covers without completely filling the trench portion 1083 that has been previously used to form a self-aligned semiconductor region with respect to the trench 108 via an ion implantation process through a bottom side and/or sidewall of the exposed trench portion 1083 (see Fig. 1F). A part of the first mask pattern 102 is exposed by an opening 1181 in the fourth mask pattern 118. The first mask pattern 102 is selectively etched with respect to any of the first spacer portion 1101 of the first spacer mask pattern 110, or the fourth mask pattern 118. After removing the fourth mask pattern 118, and, optionally, recessing the second mask pattern 112 from a side surface thereof, a spacer patterning process is carried out for forming the second spacer mask pattern 116 by a spacer layer deposition process followed by a spacer etch process. The processing features described above are exemplary processing features for processing the wide band gap semiconductor body 106 between the stages of processing illustrated in Fig. 1F and Fig. 3.

Based on the second spacer mask pattern 116 illustrated in Fig. 3, dopants are introduced into the wide band gap semiconductor body 106. For example, the dopants are introduced through an opening 1163 in the second spacer mask pattern 116 into the wide band gap semiconductor body 106 by ion implantation. Thereby, one or more n- or p-doped semiconductor regions may be formed in a self-aligned manner with respect to the edges of the trench 108. A lateral distance of the one or more n- or p-doped semiconductor regions to the trench 108 may be adjusted via a thickness of the second spacer portion 1162, for example. Varying an ion implantation tilt angle may allow for a further degree of freedom for adjusting the lateral distance of the one or more n- or p-doped semiconductor regions to the trench 108. For example, a p⁺-doped auxiliary region in an n-channel FET may be formed at a precise lateral distance to a channel region at a trench sidewall that is defined by the self-aligned process described above. The p+-doped auxiliary region may allow for electrically connecting a p-doped shielding region and/or a p-doped body region to the source electrode, for example.

Further semiconductor regions may be arranged in a self-aligned manner with respect to the trench 108 or mesa region that is defined by opposite trenches. Referring to the schematic cross-sectional view of Fig. 5, a sixth mask pattern 120 is formed, the sixth mask pattern laterally adjoining to the first and second spacer portions 1161, 1162 of the second mask pattern 116. For example, a material of the sixth mask pattern 120 may be polycrystalline silicon.

Forming the sixth mask pattern 120 may include a layer deposition process, e.g. polycrystalline silicon layer deposition process. A first part of the deposited layer fills the openings 1163 illustrated in Fig. 3 and a second part of the deposited layer covers a top side of the second spacer mask pattern 116, the first spacer mask pattern 110 and the second mask pattern 112. The second part may then be removed by CMP and/or etching. The remaining first part of the deposited layer defines the sixth mask pattern 120.

Further referring to the schematic cross-sectional view of Fig. 5, a seventh mask pattern 122 is formed over the sixth mask pattern 120. For example, a material of or the seventh mask pattern 122 may be an oxide of silicon or silicon nitride. The seventh mask pattern 122 covers a top surface of the second mask pattern 112 and a top surface of the first spacer portion 1161 of the second spacer mask pattern 116. A top surface of the second spacer portion 1162 of the second spacer mask pattern 116 is exposed by an opening 1221 in seventh mask pattern 122.

Referring to the schematic cross-sectional view of Fig. 6, a surface portion of the wide band gap semiconductor body 106 is exposed by selectively etching the second spacer portion 1162 of the second spacer mask pattern 116 with respect to any of the first spacer portion 1101 of the first spacer mask pattern 110, or the sixth mask pattern 120 or the seventh mask pattern 122. By removing the second spacer portion 1162, an opening 128 remains that exposes the wide band gap semiconductor body 106.

Through the opening 128, dopants are introduced into the wide band gap semiconductor body 106, e.g. by ion implantation. Thereby, one or more n- or p-doped semiconductor regions may be formed in a self-aligned manner with respect to the edges of the trench 102. A width of the one or more n- or p-doped semiconductor regions may be adjusted via a thickness of the second spacer portion 1162, for example. For example, an n⁺-doped source region may be formed by the dopants implanted through the opening 128.

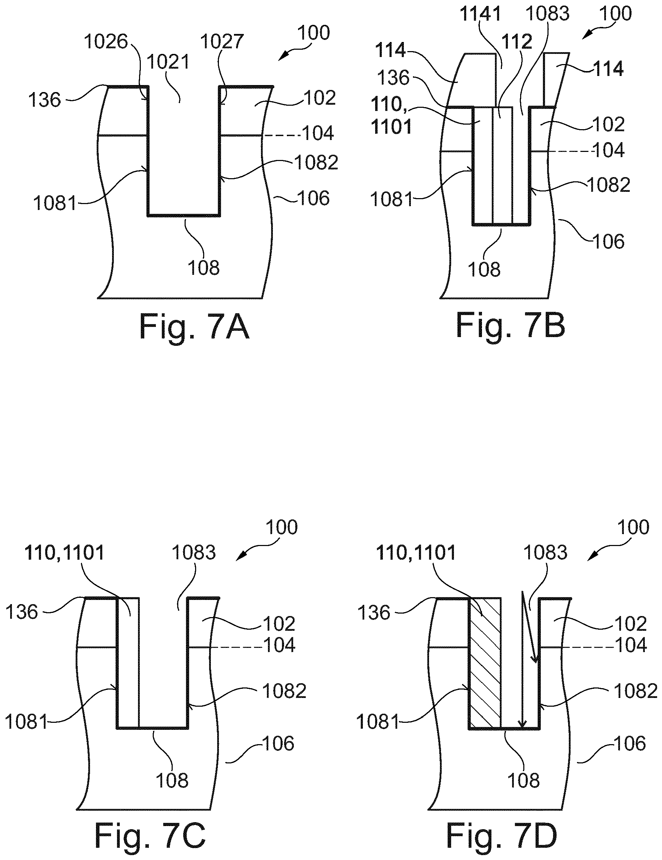

The schematic cross-sectional views of Figs. 7A to 7D illustrate exemplary process features of manufacturing a wide band gap semiconductor device.

The schematic cross-sectional view of Fig. 7A is based on the process feature illustrated in Fig. 1B and further illustrates formation of a liner 136 lining a bottom side and the sidewalls 1081, 1082 of the trench 108 and a top side and the sidewalls 1026, 1027 of the first mask pattern 102. The process features illustrated in Fig. 1C and 1D may follow before defining the second mask pattern 112.

Referring to Fig. 7B, and similar to the process feature illustrated in Fig. 2, exposing the trench portion 1083 includes forming a third mask pattern 114 over the first mask pattern 102. The third mask pattern 114 covers a top surface of the first spacer portion 1101 of the first spacer mask pattern 110. Prior to removing the second spacer portion 1102 and the second mask pattern 112 from the trench 108, a top surface of the second spacer portion 1102 of the first spacer mask pattern 110 is exposed by an opening 1141 in the third mask pattern 114. For example, the third mask pattern 114 may include a resist mask pattern and an auxiliary mask pattern between the resist mask pattern and the first spacer mask pattern 110. The auxiliary mask pattern and the second mask pattern 112 may protect the first spacer portion 1101 when etching the second spacer portion 1102 for exposing the trench portion 1083, for example. The auxiliary mask pattern may include or be formed by an oxide layer, e.g. TEOS layer, for example. After removal of the second spacer portion 1102 as illustrated in Fig. 7B and referring to Fig. 7C, the exposed the trench portion 1083 is widened by removing the second mask pattern 112, e.g. by an etch process that is selective with respect to the liner 136.

Referring to the schematic cross-sectional view of Fig. 7D, the first spacer portion 1101 may be widened, e.g. by an oxidation process. In other words, a thickness of the first spacer portion 1101 may be tuned by an appropriate process such as, for example and depending on the material of the first spacer portion 1101, by oxidation. For example, when forming the first spacer portion 1101 by polycrystalline silicon, widening of the first spacer portion 1101 may be caused by at least partly oxidizing the polycrystalline silicon. Similar to Fig. 1E, dopants are introduced through the exposed trench portion 1083 into the wide band gap semiconductor body 106. For example, a p-doped shielding region may be formed in a self-aligned manner with respect to the edges of the trench 108. The first mask 102 serves as an ion implantation mask on the mesa confined by opposite trenches 108 when implanting the dopants through the exposed trench portion 1083. For example, dopants introduced through the sidewall of the trench 108 may define an interconnection region for electrically interconnecting a buried region below the bottom side of the trench to a contact at the first surface. As an alternative or in addition, the interconnection region or part thereof may be defined by a masked ion implantation process before forming the trench 108, for example.

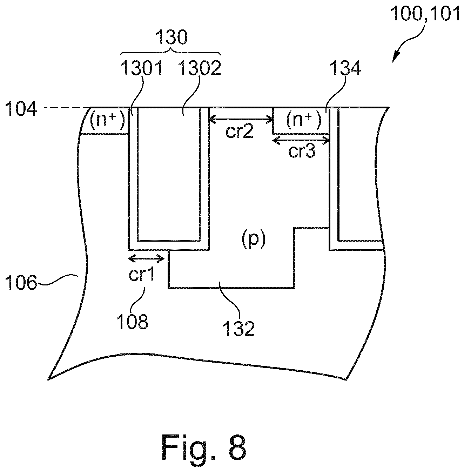

The schematic cross-sectional view of Fig. 8 illustrates a configuration example of an n-channel FET 101. Manufacturing of the n-channel FET 101 may be based on process features as described and illustrated herein. The n-channel FET 101 includes a trench gate structure 130 extending into the wide band gap semiconductor body 106 from the first surface 104. The trench gate structure includes a trench gate dielectric 1301 and a trench gate electrode 1302. The trench gate structure 130 may be formed in the trench 108 illustrated in Figs. 1B to 6 after defining the semiconductor regions in a self-aligned manner with respect to the trench as described in the examples above. A p-doped region 132 may be defined by a plurality of overlapping p-doped regions, e.g. p-doped body region, p-doped shielding region, p-doped auxiliary region. For example, a first critical dimension cr1 of a first part (e.g. p-doped shielding region) of the p-doped region 132 may be defined in a self-aligned manner to the edges of the trench 108 as described with reference to Figs. 1A to 1F. A second critical dimension cr2 of a second part (e.g. p-doped auxiliary region) of the p-doped region 132 may be defined in a self-aligned manner to the edges of the trench 108 as described with reference to Fig. 3. A third critical dimension cr3 of an n⁺-doped source region 134 may be defined in a self-aligned manner to the edges of the trench 108 as described with reference to Figs. 5, 6.

The aspects and features mentioned and described together with one or more of the previously described examples and figures, may as well be combined with one or more of the other examples in order to replace a like feature of the other example or in order to additionally introduce the feature to the other example.

Although specific embodiments have been illustrated and described herein, it will be appreciated by those of ordinary skill in the art that a variety of alternate and/or equivalent implementations may be substituted for the specific embodiments shown and described without departing from the scope of the present invention. This application is intended to cover any adaptations or variations of the specific embodiments discussed herein. Therefore, it is intended that this invention be limited only by the claims and the equivalents thereof.

## Claims

1. A method of manufacturing a semiconductor device (100), the method comprising:
forming a first mask pattern (102) over a first surface (104) of a wide band gap semiconductor body (106);
forming a trench (108) extending from an opening (1021) in the first mask pattern (102) into the wide band gap semiconductor body (106), wherein the trench (108) includes a first sidewall (1081) and an opposite second sidewall (1082);
forming a first spacer mask pattern (110) including a first spacer portion (1101) covering at least the first sidewall (1081) and a second spacer portion (1102) covering at least the second sidewall (1082);
forming a second mask pattern (112) in the trench (108) between the first spacer portion (1101) of the first spacer mask pattern (110) and the second spacer portion (1102) of the first spacer mask pattern (110);
exposing a trench portion (1083) of the trench (108) by removing at least a portion of the second spacer portion (1102) from the trench (108); and
introducing dopants through the trench portion (1083) into the wide band gap semiconductor body (106).

2. The method of the preceding claim, wherein exposing the trench portion (1083) includes:
forming a third mask pattern (114) over the first mask pattern (102), wherein the third mask pattern (112) covers a top surface of the first spacer portion (1101) of the first spacer mask pattern (110), and wherein a top surface of the second spacer portion (1102) of the first spacer mask pattern (110) is exposed by an opening (1141) in the third mask pattern (114).

3. The method of the preceding claim, wherein exposing the trench portion (1083) further includes:
selectively etching the second spacer portion (1102) of the first spacer mask pattern (110) with respect to any of the first mask pattern (102), or the second mask pattern (112), or the third mask pattern (114).

4. The method of any of the preceding claims, wherein a material of the first spacer portion (1101) of the first spacer mask pattern (110) is polycrystalline silicon, and a material of at least one of the first mask pattern (102) or the second mask pattern (112) is an oxide of silicon.

5. The method of any of the preceding claims, wherein introducing dopants through the trench portion (1083) into the wide band gap semiconductor body (106) includes introducing dopants through a bottom side or the second sidewall (1082) of the trench (108) into the wide band gap semiconductor body (106) by ion implantation.

6. The method of any of the preceding claims, further comprising:
removing the first mask pattern (102); and
forming a second spacer mask pattern (116) including a first spacer portion (1161) in the trench portion (1083) between the wide band gap semiconductor body (106) and the second mask pattern (112), and a second spacer portion (1162) laterally adjoining to the first spacer portion (1101) of the first spacer mask pattern (110).

7. The method of the preceding claim, wherein removing the first mask pattern (102) includes:
forming a fourth mask pattern (118) over the first mask pattern (102), wherein the fourth mask pattern (118) covers a top surface of the second mask pattern (112) and a top surface of the first spacer portion (1101) of the first spacer mask pattern (110), and a part of the first mask pattern (102) is exposed by an opening (1181) in the fourth mask pattern (118).

8. The method of the preceding claim, wherein removing the first mask pattern (102) further includes:
selectively etching the first mask pattern (102) with respect to any of the first spacer portion (1101) of the first spacer mask pattern (110), or the fourth mask pattern (118).

9. The method of any of the three preceding claims, further comprising introducing dopants through an opening (1163) in the second spacer mask pattern (116) into the wide band gap semiconductor body (106) by ion implantation.

10. The method of any of the four preceding claims, further comprising:
forming a sixth mask pattern (120) laterally adjoining to the first and second spacer portions (1161, 1162) of the second mask pattern (116); and
forming a seventh mask pattern (122) over the sixth mask pattern (120), wherein the seventh mask pattern (122) covers a top surface of the second mask pattern (112) and a top surface of the first spacer portion (1161) of the second spacer mask pattern (116), and wherein a top surface of the second spacer portion (1162) of the second spacer mask pattern (116) is exposed by an opening (1221) in seventh mask pattern (122).

11. The method of the preceding claim, further comprising:
exposing a surface portion of the wide band gap semiconductor body (106) by selectively etching the second spacer portion (1162) of the second spacer mask pattern (116) with respect to any of the first spacer portion (1101) of the first spacer mask pattern (110), or the sixth mask pattern (120) or the seventh mask pattern (122).

12. The method of the preceding claim, further comprising introducing dopants through the surface portion of the wide band gap semiconductor body (106) into the wide band gap semiconductor body (106) by ion implantation.

13. The method of any of the preceding claims, further comprising, before forming the first mask pattern (102), introducing dopants through the first surface (104) into the wide band gap semiconductor body (106).

14. The method of any of the preceding claims, further comprising, after forming the trench (108) and before forming the first spacer mask pattern (110):
forming a liner (136) lining a bottom side and sidewalls (1081, 1082) of the trench (108) and the top side and the sidewalls 1026, 1027 of the first mask pattern (102).

15. The method of any the preceding claim, wherein exposing the trench portion (1083) further includes removing at least a portion of the second mask pattern (112).
